# EUROPEAN PATENT APPLICATION

(11) **EP 1 988 582 A1**
(43) Date of publication of application: **05.11.2008**
(21) Application number: 07702257.2
(22) Date of filing: 02.02.2007
(51) Int. Cl.: H01L 31/052, H01L 31/04

(54) **A CONDENSING TYPE SOLAR CELL APPARATUS**

(30) Priority: 09.02.2006 CN 200610054633
(71) Applicant: Yi, Binxuan, Guangdong 518129 (CN)
(72) Inventor: Yi, Binxuan, Guangdong 518129 (CN)
(74) Representative: Cabinet Plasseraud
(86) International application number: PCT/CN2007/000365
(87) International publication number: WO 2007/090339

(57) **Abstract**

A concentrating solar cell apparatus is disclosed, comprising a concentrating assembly, a solar cell assembly and a heat dissipation assembly. The concentrating assembly concentrates light rays in a large area on a focus by the well-known concentrating theory of concave mirror. The solar cell assembly is composed of plurality of quadrate solar cell pieces and is mounted on side surfaces of a support, said support being closely connected with the solar cell pieces and a parabolic base, so as to form a heat conducing path and compose the heat dissipation assembly, so that a great deal of heat received by the solar cell pieces is dispersed via the heat conducing path, and the purposes of concentrating light in a desired super-high rate and dissipating heat in time is therefore realized.

## Description

### FIELD OF THE INVENTION

The present invention provides a solar cell apparatus, particularly adapted for a photovoltaic power generation system composed of monocrystalline or polycrystalline silicon solar cell panels. The present invention is in the field of solar photovoltaic power generation.

### BACKGROUND OF THE INVENTION

Presently, a solar photovoltaic power generation system requires a great deal of monocrystalline or polycrystalline silicon. However, the technologies for producing high-purity monocrystalline and polycrystalline silicon are monopolized in several foreign high-tech enterprises, which results in the price of crystalline silicon staying high. Thus the popularization and application in wide areas for solar power generation project are suffocated presently. Solar cell panel is not accepted by many Chinese markets because of its high price. Meanwhile, Chinese and foreign experts have found under research that the crystalline silicon photovoltaic cell used under normal sun light intensity are actually underemployed, because the photovoltaic cell can endure higher light intensity and increase electric current generated by the photovoltaic cell proportionally without effecting its life. If the light intensity of area of photovoltaic cell can be increased by concentrating the light in scores or even hundreds of times, the area of photovoltaic cell for outputting same amount of electric current can be significantly decreased. In this way, the amount of crystalline silicon used in the solar cell panel can be significantly decreased, so that the price of the solar cell can be significantly decreased to a level that can be accepted by a user.

There are several industrial attempts in both China and foreign countries for increasing the efficiency of power generation from solar by light concentration, such as, realizing 3-7 times light concentration by Fresnel lens. However, the intensity uniformity of the light concentrated through transmission is bad, while the decreasing speed of the cost of a special lens can not catch up with that of a plane mirror with high reflectivity. Accordingly, in both China and foreign countries, the attempt for realizing light concentration by reflection are carried on, such as, a V-typed concentrator invented by ZSW company in Germany which realizes 2 times light concentration, a tetrahedron concentrator invented by Falbel in America which realizes 2.36 times light concentration, and a octahedron concentrating funnel provided by Chinese experts which realizes 4.8 times light concentration, and the likes. All of these above-mentioned ways can only realize light concentration of less than 10 times, which can not solve the problem of concentrating light in high times. Accordingly, its cost-effective is not desirable and can not realize the purpose of popularization and application at wide areas.

### SUMMARY OF THE INVENTION

It is the objective of the invention to provide a solar cell apparatus for realizing several decade to hundred times multiple light concentrating light in scores or even hundreds of times by providing a concentrating assembly and a heat dissipation assembly.

In order to achieve the above objective, the technical solution of the invention is to provide a concentrating solar cell apparatus comprising: a concentrating assembly including a parabolic base, and a reflecting mirror provided at and laid over an inner side of said parabolic base; a solar cell assembly including a support perpendicularly provided at the center of the underside of said parabolic base, and a plurality of solar cell pieces provided around a free-end of said support and connected with each other in series, said solar cells being provided around a concentrating focus of the reflecting mirror of said concentrating assembly; and a heat dissipation assembly connected with said support.

Said concentrating solar cell apparatus is characterized in that said reflecting mirror is composed of a plurality of plane mirrors having small areas.

Said concentrating solar cell apparatus is characterized in that said heat dissipation assembly is provided at an outer side of said parabolic base.

Said concentrating solar cell apparatus, wherein said support is a hollow structure for containing wires of said solar cells.

Said concentrating solar cell apparatus is characterized in that said heat dissipation assembly is provided inside of the hollow structure of said support. Said concentrating solar cell apparatus, wherein said support is made from materials with good heat conducting performance.

Said concentrating solar cell apparatus, wherein said support is made of aluminum alloy or copper alloy materials.

Said concentrating solar cell apparatus, wherein the arc bottom of said parabolic base is configured into an interceptive plane.

Said concentrating solar cell apparatus, wherein said solar cell pieces closely contact with said support through isolating and high heat-conducting material.

Said concentrating solar cell apparatus, wherein said heat dissipation assembly further comprises a fan.

Said concentrating solar cell apparatus, wherein the parabolic surface of said parabolic base has a diameter of 1.2-5 meters.

The concentrating solar cell apparatus of the present invention comprises a concentrating assembly, a solar cell assembly and a heat dissipation assembly; wherein the concentrating assembly comprises a parabolic base and a reflecting mirror. The reflecting mirror can be formed of plurality of small pieces of plane mirrors covering the inner side of the parabolic base; or be formed of metal material of the parabolic base, the inner side of which is polished. The concentrating assembly concentrates light rays in a large area on a focus by the well-known concentrating theory of concave mirror. The solar cell assembly is composed of four (or plurality of) quadrate (such as 2mm×50mm) solar cell pieces mounted on four (or plurality of) sides of a support. The cell pieces closely contact with the support through isolating and high heat-conducting material provided between them, so as to allowing the four (or plurality of) solar cell pieces be arranged on the focus of the concentrating assembly, for collecting the concentrated super light rays. The support, which supports said four (or plurality of) solar cell pieces, is perpendicularly connected to the center middle of the parabolic base and make them contact well. The heat dissipation is composed of the support, which is made form aluminum alloy (or copper alloy) material having good heat-conducting performance, and the parabolic base having same good heat-conducting performance as the support. The parabolic base is made from the same material and having a great lot of heat sinks on the outer side of the parabolic base to increase the area of heat dissipation. The support is configured into a form of a hollow conduit, the central hole of which is provided for leading wires of the solar cell pieces.

As another embodiment of the present invention, the heat sinks can also be provided within the hollow space of the hollow conduit of the support, so that the heat generated by the solar cell pieces can also be conducted outside rapidly through the support and the heat sinks therein. Meanwhile, the heat dissipation assembly of such structure has more compact structure, shorter heat dissipation path and better effect.

The concentrating solar cell apparatus of the present invention subtly forms a heat conducting path by means of the support and the parabolic base of the solar cell pieces, so that, although the solar cell pieces located on the focus of sun light rays receive concentrating light rays in super high rate and very high heat, the heat can be conducted rapidly to the material of the support due to the good contact between the solar cell pieces and the support, and rapidly to the parabolic base and then to the heat sinks having large area at the back of the parabolic base; or be conducted outside though the support and the heat sinks inside it. Due to heat dissipation area of this part is very large and is not irradiated by sun ( it is because the present apparatus needs to be controlled by a sun automatically following system so as to make a straight sun light status to the concentrating cell apparatus all the time), the most of the concentrated heat is dispersed. The theory temperature of the solar cell pieces (on the focus) of this structure is not more than 60°C under natural cooling condition, as long as the conducting contact is good.

Depending on the needs of light concentrating rate, different light concentrating rate can be realized by adjusting the size of the parabolic surface, the height of the support and the diameter of the support in the apparatus of the invention. For example, to realize a requirement for 30-40 times light concentrating, the apparatus of the invention can be configured so that the parabolic diameter of the parabolic base is of 1.8 meters, the height of the support from the focus to the parabolic arc bottom is of 45 cm, and the diameter of the support is of 25cm. In general, the diameter of the parabolic base can be chosen between 1.2-5 meters. For the design requirement of higher light concentrating times, if necessary, a fan device can be further provided in the heat dissipation assembly such that the heat conducted to the underside heat sink through the support can be dispersed more quickly.

The concentrating solar cell apparatus of the present invention is provided with the concentrating assembly and the heat dissipation assembly, so that the light concentrating rate of the cell apparatus is increased greatly and a great deal of heat concentrated on the focus of sun light can be conducted outside rapidly through the heat sinks. The power generation by using such concentrating solar cell apparatuses in series is of good consistency and high stability. The solar cell pieces can be sufficiently employed and the cost of solar photovoltaic power generation can be decreased greatly.

### BRIEF DESCRIPTION OF THE DRAWINGS

Fig.1 is a projection view of a concentrating solar cell apparatus of the present invention;

Fig.2 is a perspective view of the parabolic base of the apparatus in Fig. 1;

Fig.3 is a side view of the concentrating solar cell apparatus of the present invention;

Fig.4 is a structural schematic view of heat dissipation in one embodiment of the present invention.

### DETAILED DESCRIPTION OF THE PREFERRED EMBODIMENT

The present invention will be illustrated in further details by describing the preferred embodiments of the present invention combining the accompanying drawings.

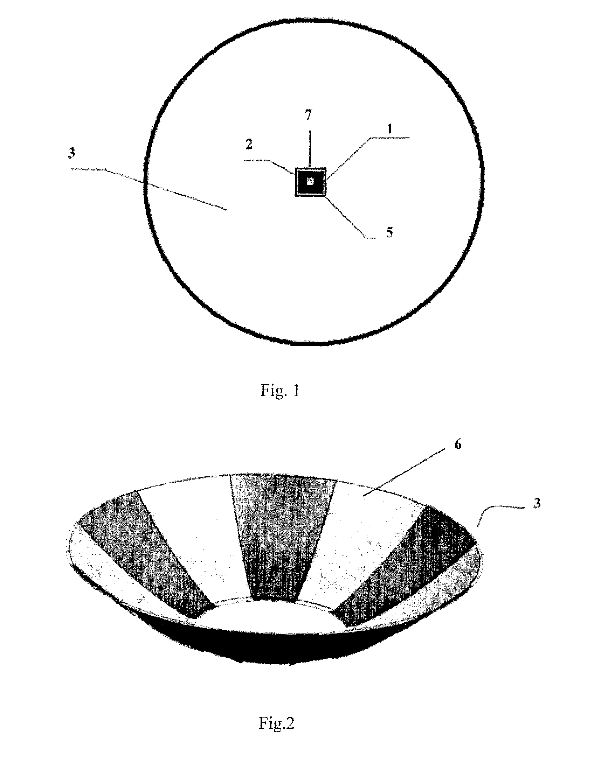

One embodiment of the present invention is shown in Fig.1. Four (or plurality of) solar cell pieces 1, which are mounted on four (or plurality of) sides of a support 2, compose a solar cell assembly and closely contact with the support 2 through isolating and high heat-conducting silica gel. The support 2 is mounted on the center middle of a parabolic base 3. As shown in Fig. 2, a concentrating assembly is composed of a great lot of small pieces of plane mirrors 6 mounted on the inner side of the parabolic base 3. The solar cell pieces 1 are arranged around a focus 7 of reflected light rays from the plane mirrors 6. There are a great lot of heat sinks 4 on the outer side of the parabolic base 3. The parabolic arc bottom of the base 3 is configured into an interceptive plane to be adaptable to place and mount the heat sinks. A heat dissipation assembly is composed of the support 2, the parabolic base 3 and the heat sinks 4 on the outer side of the parabolic base 3, wherein the support 2 is in form of a hollow conduit and having a small hole 5 in its middle for leading wires of the solar cell assembly. The support 2 and the parabolic base 3 are made from materials with good heat-conducting performance in order to be convenient for dissipating heat quickly.

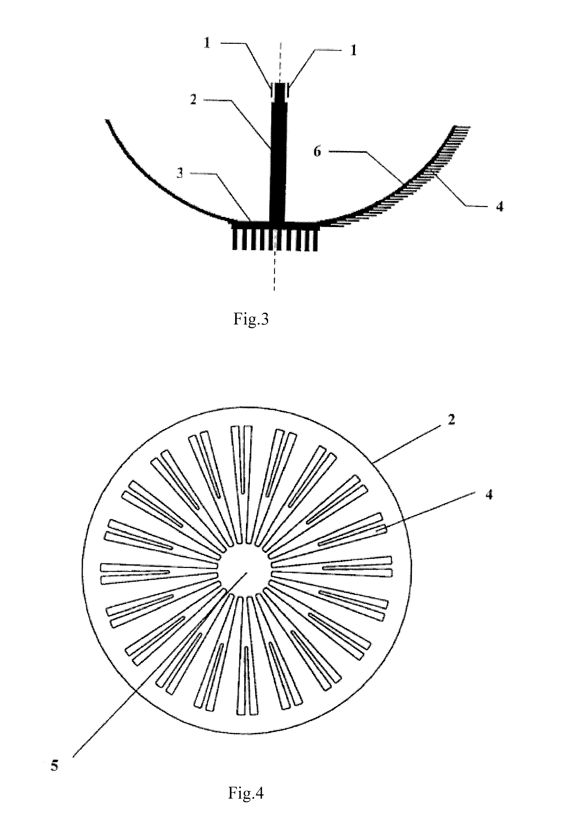

The left and the right sides of Fig. 3 is symmetrical along the center dashed line, i.e., there are heat sinks on both the left and the right parabolic back side, wherein the heat sinks on the left are not drawn for the purpose of showing the shape. Also for the purpose of showing, the solar cell pieces 1 do not contact the support 2 directly, however, they should be on close contact each other through a layer of isolating and high heat-conducting silica gel provided between them.

When in working, sun lights are reflected and focused to the solar cell pieces 1 through the plane mirrors 6. The electric current generated by the solar cell pieces 1 is conducted and outputted through the wires provided within the support 2. Meanwhile, a great deal of heat concentrated is conducted rapidly to the parabolic base 3 and the heat sinks 4 provided on the outer side of the base through the support 2 contacted with the solar cell pieces closely and is dispersed quickly. By this way, the solar cells can endure concentrating intensity in scores of to hundreds of times. The electric current generated can be increased proportionally while the work temperature can be maintains in normal. The work efficiency of the solar cell is increased greatly.

Another preferred embodiment of the heat dissipation assembly of the present invention is shown in Fig. 4. Plurality of heat sinks 4 can be provided in the inner hollow structure of the support 2. The length of the heat sink 4 can be equal to that of the support 2. The heat generated by the solar cell pieces can be conducted to the heat sinks 4 through the support 2 and conducted outside quickly through the hole therein.

The above description of the present invention is not the limit to the present invention. According to the present invention, those skilled in the art can make various changes and variations, which should belong to the scope of the attached claims if only they do not depart from the spirit of the present invention.

## Claims

1. A concentrating solar cell apparatus, comprising:
a concentrating assembly, including:
a parabolic base, and
a reflecting mirror provided at and laid over an inner side of said parabolic base;
a solar cell assembly, including:
a support perpendicularly provided at the center of the underside of said parabolic base; and
a plurality of solar cell pieces provided around a free-end of said support and connected with each other in series, said solar cell pieces being arranged around a concentrating focus of the reflecting mirror of said concentrating assembly; and
a heat dissipation assembly connected with said support.

2. The concentrating solar cell apparatus according to claim 1, wherein said reflecting mirror is composed of a plurality of plane mirrors having small areas.

3. The concentrating solar cell apparatus according to claim 1, wherein said heat dissipation assembly is provided at an outer side of said parabolic base.

4. The concentrating solar cell apparatus according to claim 1, wherein said support is of a hollow structure for containing wires of said solar cells.

5. The concentrating solar cell apparatus according to claim 1 wherein said heat dissipation assembly is provided inside the hollow structure of said support.

6. The concentrating solar cell apparatus according to claim 1, wherein said support and said parabolic base are made from materials with good heat-conducting performance.

7. The concentrating solar cell apparatus according to claim 6, wherein said support and parabolic base are made from aluminum or copper materials.

8. The concentrating solar cell apparatus according to claim 1, wherein the arc bottom of said parabolic base is configured into an interceptive plane.

9. The concentrating solar cell apparatus according to claim 1, wherein said solar cells closely contact with said support through isolating and high heat-conducting material.

10. The concentrating solar cell apparatus according to claim 1, wherein said heat dissipation assembly further comprises a fan.

11. The concentrating solar cell apparatus according to claim 1, wherein the parabolic surface of said parabolic base has a diameter of 1.2-5 meters.
